# EUROPÄISCHE PATENTSCHRIFT

(11) **EP 1 882 052 B1**
(45) Veröffentlichungstag und Bekanntmachung des Hinweises auf die Patenterteilung: **01.08.2012**
(21) Anmeldenummer: 06742936.5
(22) Anmeldetag: 16.05.2006
(51) Int. Cl.: C23C 16/40, C08J 7/00

(54) **VERFAHREN ZUM MODIFIZIEREN EINER SILIKONKAUTSCHUKOBERFLÄCHE**
METHOD FOR MODIFYING A SILICONE RUBBER SURFACE
PROCEDE DE MODIFICATION D'UNE SURFACE EN CAOUTCHOUC DE SILICONE

(30) Priorität: 19.05.2005 DE 102005023018; 19.05.2005 DE 102005023017
(43) Veröffentlichungstag der Anmeldung: 30.01.2008
(73) Patentinhaber: RAUMEDIC AG, 95213 Münchberg (DE)
(72) Erfinder: ARLT, Joachim, 09669 Frankenberg (DE); QUANDT, Edgar, 95185 Gattendorf (DE)
(74) Vertreter: Hofmann, Matthias
(86) Internationale Anmeldenummer: PCT/EP2006/004596
(87) Internationale Veröffentlichungsnummer: WO 2006/122744

(56) Entgegenhaltungen:
- EP-A- 0 151 233
- EP-A- 0 594 171
- EP-A- 1 475 459
- EP-A- 1 602 633
- EP-A2- 0 329 041
- DD-A- 256 151
- DE-A1- 1 491 682
- DE-A1- 19 905 697
- GB-A- 1 333 598
- JP-A- 7 256 780
- US-A- 5 736 251

## Beschreibung

Die Erfindung betrifft ein Verfahren zur Herstellung eines Schlauchs. Ferner betrifft die Erfindung einen Schlauch aus Silikonkautschuk mit einer nach diesem Verfahren modifizierten Silikonkautschukoberfläche.

Silikonkautschuk wird aufgrund seines außerordentlich günstigen Eigenschaftsprofils und seiner breiten Modifizierbarkeit in vielfältigen Anwendungen eingesetzt.
Ein wichtiges Anwendungsgebiet ist der medizinische Sektor, hier insbesondere die Anwendung Katheterschläuche.

Silikonkautschukoberflächen sind rezepturbedingt extrem "klebrig" bzw. haben eine hohe Adhäsionsneigung. Dieser Nachteil wirkt sich sowohl bei der Herstellung von Artikeln als auch bei ihrer Anwendung aus. In den meisten Fällen wird daher diese Klebrigkeit durch eine nachträgliche Behaudlung der Oberfläche reduziert.
Dies geschieht in der Regel durch den Auftrag von Trennmitteln, beispielsweise auf Basis von Ölen oder durch Pudern mit Talkum.

Nachteilig ist dabei nicht nur diese kostenintensive nachträgliche Behandlung, sondern auch - vor allem für die Anwendungen im Medizinbereich dass die Öle bzw. das Talkum eine Festigung unter Reinraumbedingungen erschweren oder gar unmöglich machten. Des Weiteren kommen bei Kathetern zusätzlich noch Gleitmittel zum Einsatz.

Einen Versuch, diesen Nachteil zu überwinden, beschreibt die DE 198 39 996 B4, wo mittels eines Plasmapolymerisationsverfahrens ein Überzug auf einer polymeren Oberfläche abgeschieden wird.
Nachteilig ist hier jedoch, dass dieses Verfahren grundsätzlich im Vakuum abläuft und daher außerordentlich kostenintensiv, darüber hinaus nur für Schläuche, geeignet ist. Die Beschichtung von Formteilen gemäß DE 198 39 996 B4 ist nicht möglich.

Ein Pyrolyseverfahren bei Atmosphärenbedingungen zur Modifizierung von Rohroberflächen bei Normaldruck beschreibt beispielsweise die DD 253257 A1.
Hier wird auf einem Metallrohr eine innere und/oder äußere Beschichtung durch ein SiOx-C-Haftvermittlerschichtsystem aufgebracht und so eine Verbesserung der Haftung von Kunststoffbeschichtungen auf dem Rohr gewährleistet.
Nachteilig ist jedoch, dass hierzu ein zusätzliches Temperiersystem in Form einer Hoch- oder Mittelftequenzspule und ein Silanauftragssystem über ein Sprühsystem, Schwamm, Filz oder Bürstenabstreicher erforderlich sind.

Tn der EP 1 475 459 A1 ist ein Verfahren zur Aufbringung einer Funktionsschicht auf einer Substratoberfläche beschrieben. Bei dem Substrat kann es sich um Silikonkautschuk handeln. Mittels eines Brenners wird eine Flammbeschichtung vorgenommen. Als schichtbildendes Gas werden eine Alkoxysilanverbindung oder Tetramethylsihm erwähnt. Die hierdurch hergestellte Funktionsschicht soll die Aufbringung eines Aufdrucks oder von Farbe auf ein Substrat erleichtern.

Aus der DE 199 05 697 A 1 ist eine Flammbeschichtung einer Materialoberfläche mit einer haftfesten Silikatschicht beschrieben. Die Silikatschicht dient als Zwischenschicht für eine nachfolgend noch aufzubringende Haftsilanschicht, auf die wiederum ein organischer Klebstoff oder ein Lack aufgetragen wird. Als Brenngas wird bei der Flammbeschichtung ein Alkan eingesetzt. In der DE 199 05 697 A1 ist die DD 256 151 A1 diskutiert. Im Zusammenhang mit der DE 256 151 A1 ist in der DE 199 05 697 A1 angegeben, dass beim Verfahren nach der DD 256 151 A1 ein Gehalt von 2 % Tetraethoxilan im Brenngas eingesetzt wird.

Aus der US 5,736,251 ist ein Verfahren zur Verbesserung der Gleiteigenschaften von Silikonkautschukoberflächcn bekannt. Weitere Verfahren zur Behandlung von Silikonoberflächen sind bekannt aus der DE 14 91 682 A1, der EP 0 329 041 A2 und der GB 1 333 598 A.

Die JP 07-256 780 A offenbart ein Verfahren zur Koextrusion einer linienförmigen Farbmarkierung in einem transparenten Silikonkautschukschlauch.

In der DE 197 48 606 A1 ist ein Plasmaverfahren zur Erzeugung oberflächlich hydrophilierter Silikonelastomere beschrieben. Die Schichtdickcn liegen im 10 µm-Bereich.

Die US 2002/0098364 A1 und die WO 94/111 118 A 1 beschreiben Plasma-Beschichtungsverfahren.

Aufgabe der vorliegenden Erfindung ist es, ein einfaches, kostengünstiges Verfahren bereitzustellen, das bei Normaldruck abläuft, für die Beschichtung von Profil und Formteilen gleichermaßen geeignet ist, in die Fertigungslinie von Silikonkautschukarlikeln leicht integrierbar ist und das cinen Schlauch mit einer Silikonkautschukoberfläche mit sehr geringer Adhäsion bzw. Klebrigkeit erzeugt.
Eine weitere Aufgabe der Erfindung ist es, einen Schlauch mit einer entsprechend modifizierten Silikonkautschukoberfläche anzugeben, die eine sehr geringe Adhäsion bzw. Klebrigkcit aufweist.

Die Aufgabe hinsichtlich des Verfahrens konnte gelöst werden durch ein Verfahren mit den Merknnalen gemäß Anspruch 1.
Bevorzugte Ausführung und Weiterbildungen sind in den Unteransprüchen aufgeführt..

Das erfindungsgemäße Verfahren scheidet auf der zu beschichtenden Silikonkautschukoberfläche aus einer schichtbildenden siliciumorganischen Verbindung pyrolytisch eine vorzugsweise 40 bis 100 nm dicke Schicht ab, welche silikathaltig ist und insbesondere die Zusammensetzung [SiO₂(OH)]ₙ, aufweist.

Diese Schicht kann unter Atmosphärendruck abgeschieden sein, es ist aber auch möglich, diese bei anderen Drücken abzuscheiden.

Diese Sitanol-/Siloxanschicht haflet naturgemäß auf Silikonkautschukoberflächen ausgezeichnet, wobei sie nahezu frei von Fehlstellen ist.

Durch die aufgebrachte Schicht ist die Silikonkatitschukoberfläche derart modifiziert, dass sie nur eine sehr geringe Adhäsion bzw. Klebrigkeit aufweist.

Eine Gaszusammensetzung nach Anspruch 2 hat sich für die Herstellung einer im Wesentlichen adhäsions freien Funktionsschicht als besonders vorteilhaft herausgestellt. Dabei war Überraschend, mit welch geringen Mengen schichtbildenden Gases gearbeitet werden kann.

Abstände zwischen dem Flammenkegel und der Silikonkautschukoberfläehe nach Anspruch 10 sowie Führungs-Relativgeschwindigkeiten nach Anspruch 11 haben sich zum effizienten Abscheiden der silikathaltigen Funktionsschicht als besonders geeignet herausgestellt.

Je nach der Form eines Gegenstands-Grundkörpers, auf den abgeschieden werden soll, haben sich Düsenkopf-Ausgestaltungen nach Anspruch 12 als vorteilhaft herausgestellt.

Eine Beschichtung innerhalb einer Fertigungsstrecke für den Gegenstand nach Anspruch 13 ist besonders effizient.

Was den Gegenstand angeht, ist die Aufgabe erfindungsgemäß gelöst durch die Merkmalskombination des Anspruches 14.

Die Vorteile des Gegenstandes entsprechen denjenigen, die vorstehend unter Bezugnahme auf das Herstellungsverfahren für die Funktionsschicht nach den Ansprüchen 1 bis 13 erwähnt wurden.

Der erfindungsgemäße Gegenstand findet insbesondere in der Medizintechnik als Schlauch Verwendung, insbesondere als Katheterschlauch oder Drainageschlauch oder ECC-Normschlauch.

Alternativ ist es möglich, den erfindungsgemäßen Gegenstand als Schlauch, in Anwendungen bei Heizschränken, Laborgeräten, Küchengeräten, beispielsweise als Backofendichtungen, und in der Automobiltechnik einzusetzen.

Artikel aus Silikonkautschuk weisen eine nach dem erfindungsgemäßen Verfahren modifizierte Oberfläche auf, die nur eine sehr geringe Adhäsion bzw. Klebrigkeit zeigt und damit vorteilhaft ohne weitere Oberflächenbehandlungen im Produktionsprozess gehandlet und in ihren Anwendungen genutzt werden können.

Nachfolgend wird die Erfindung im Detail beschrieben.

Hierzu zeigen folgende Figuren:
- Fig. 1: die ungefähre Zusammensetzung der abgeschiedenen Silanol-/Siloxanschicht;

- Fig. 2: eine Prinzipdarstellung einer Flamme mit dem oxidierenden und dem reduzierenden Bereich;
- Fig. 3a, 3b: eine grafische Darstellung der Ergebnisse eines Reibungstests als Krall-Weg-Diagramm an einem Ausführungsbeispiel der Erfindung, wobei Fig. 3a das Ergebnis mit der auf die Silikonkautschukobertläche aufgebrachten Schicht zeigt, Fig. 3b das ohne die entsprechende Schicht.

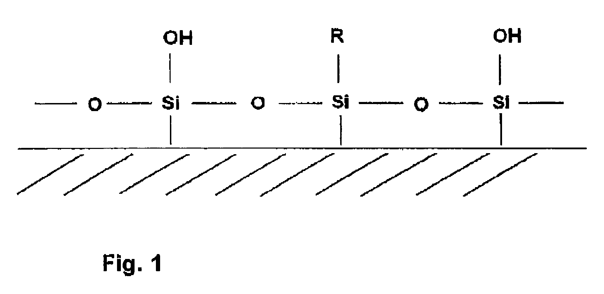

In Fig. 1 ist die ungefähre Zusammensetzung der durch die Flamme bei Atmosphärendruck abgeschiedenen Silanol-/Siloxanschicht dargestellt.

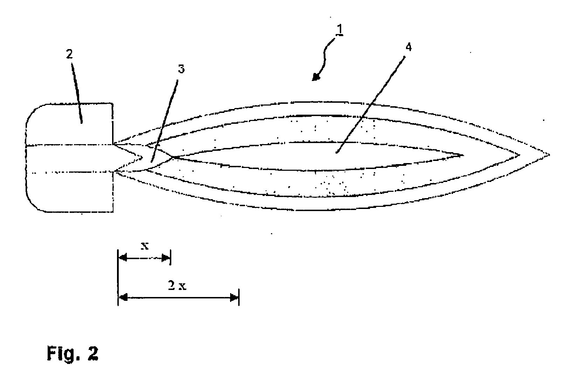

Fig. 2 zeigt eine Prinzipdarstellung einer flamme 1 mit dem oxidierenden und dem reduzierendem Bereich.
Die Flamme wird mittels eines Düsenkopfes 2 erzeugt.

Die Flamme 1 bildet eine oxidierende Zone 3 und eine reduzierende Zone 4 aus.

Dem Düsenkopf 2 werden aus einer Gasversorgungseinheit
- ein Brenngas,
- Luft als Sauerstoff lieferndes Gas,
- ein schichtbildendes Gas
zugeführt.

Als Brenngase eignen sich Propan, Butan, Methan oder Erdgas. Als Brenngas kann aber auch Wasserstoff eingesetzt werden.

Es kann anstatt Luft auch Sauerstoff, oder ein Sauerstoff enthaltendes Gasgemisch in den Düsenkopf eingespeist werden.

Hexamethyldisiloxan (HMDSO) oder Tetramethoxysilan oder Tetraethoxysilan oder ein anderes Alkoxysilan oder Trimethylsilan können als schichtbildendes Gas verwendet werden. Es ist auch möglich, verschiedene zyklische Silanverbindungen einzusetzen.
Flüssige Verbindungen werden dazu mit geeigneten Techniken in die Gasphase überführt.

Die Durchsätze von Brenngas und Luft sind dabei derart zu wählen, dass sich eine möglichst intensive, hellblaue Flammenfärbung einstellt.
Ein Verhältnis der Gasmengen Brenngas : Luft von 1 : 15 bis 1 : 25, vorzugsweise von 1 : 20 hat sich hierbei als besonders geeignet erwiesen.

Dem so gewählten Brenngas-Luft-Germisch ist das schichtbildende Gas nur in sehr geringem Anteil beigemischt.
Dabei wird hier ein Anteil des schichtbildenden Gases von ca. 0,1 bis 1 %, vorzugsweise von 0,2 bis 0,4 % am Gesamtgasstrom eingesetzt.

Nach der Entzündung der Flamme 1 wird deren thermische Leistung einerseits und der Abstand des Flammenkegels von der zu beschichtenden Oberfläche andererseits so gewählt, dass das Substrat thermisch nicht geschädigt wird.

Als Flammenkegel ist in diesem Zusammenhang die Grenze zwischen der oxidierenden Zone 3 und der reduzierenden Zone 4 der Flamme 1 definiert. Um eine haftfeste, dichte Beschichtung zu erzielten, ist die Silikonkautschukoberfläche innerhalb der reduzierenden Zone 4 nahe des Flammkegels zu positionieren.
Wird der Abstand Düsenspitze zu Flammkegelspitze als x definiert, so ist die Oberfläche in einem Abstand von x bis 2x, vorzugsweise von x bis 1,5x von der Düsenspitze entfernt anzuordnen.

Zur Beschichtung profilförmiger Elemente wird der Düsenkopf zweckmäßiger Weise aus einer Ringdüse bestehen, deren Einzeldüsen an ihrer Innenseite, also zum zu beschichtenden Substrat hin, angeordnet sind. Besonders vorteilhaft lassen sich Profile beschichten, wenn der Düsenkopf so gebaut ist, dass er einen kegelförmig abgeschrägten Bereich aufweist, in den das Profil einläuft, wobei in diesem Bereich Düsen zur Erzeugung der Flamme angeordnet sind. Der Öffnungswinkel des Kegels kann dabei 10° bis 80° betragen. Hierdurch wird erreicht, dass eine besonders homogene und gleichmäßige Abscheidung der silikathaltigen Funktionsschicht stattfindet.

Im Falle der Beschichtung von flächigen oder annähernd flächigen Teilen oder von entsprechend komplex gestalteten Formteilen besteht der Düsenkopf aus einer linearen oder annähernd linearen Anordnung von Einzeldüsen.

Zum Aufbringen der Beschichtung und zur Vermeidung der Substratüberhitzung durch die beschichtende Flamme kann eine Relativbewegung zwischen Düsenkopf und Substrat erforderlich sein.

Im Falle der Beschichtung von Profilelementen werden diese in der Regel mechanisch über Rollen oder dergleichen geführt und an der Flamme vorbei bewegt, dabei ist dann der Düsenkopf fixiert.

Sind Formteile mit komplexer Geometrie zu beschichten, kann zweckmäßiger Weise das zu beschichtende Teil fixiert und der Düsenkopf beispielsweise über einen computergesteuerten Arm in geeigneter Weise an der Oberfläche des Formteils vorbei bewegt werden.

Die relative Vorschubgeschwindigkeit der beschichtenden Flamme im Verhältnis zur Oberfläche des zu beschichtenden Formteils aus Silikonkautschuk beträgt erfindungsgemäß vorzugsweise 10 bis 20 m/min, mit Grenzwerten von minimal 1 und maximal 50 m/min.

Es kann dabei auch vorgesehen sein, die Beschichtung mehrmals aufeinanderfolgend zu wiederholen und damit mehrlagige Beschichtungen zu erzeugen. Dies kann durch mehrmaliges Überstreichen mit einer Flamme geschehen oder durch die Anordnung mehrerer Ringdüsen bei der Beschichtung von Profilen.

Von besonderem Vorteil bei dem erfindungsgemäßen Verfahrens ist die Möglichkeit, es in die Extrusionslinie zur Herstellung von Schläuchen, Rohren oder Profilen integrieren zu können, so dass eine kostengünstige Inline-Beschichtung realisierbar ist.

Durch das erfindungsgemäße Verfahren zur Modifikation von Silikonkautschukoberflächen wird die Reibungs- und Adhäsionseigenschaft der Oberfläche entscheidend verändert.

Messkurven zeigen, dass die Beschichtung das Gleitverhalten signifikant ändert und der am nicht beschichteten Substrat auftretende Slip-Stick-Effekt nahezu eliminiert ist.

Ebenso ist die Neigung des adhäsiven Haftens auf der Silikonoberfläche durch die Modifikation drastisch reduziert.

Nachfolgend wird anhand eines Ausfuhrungsbeispiels die Beschichtung eines Schlauches aus Silikonkautschuk für die Anwendung als medizinischer Katheter beschrieben.

### Ausführungsbeispiel:

In einer Extrusionslinie wird aus einer HTV(hochtemperaturvemetzende)-Silikonkautschuk-Mischung für Shore-Härte A 60 ein Schlauch mit den Abmessungen 2,7 mm x 0,6 mm in einer Geschwindigkeit von 20 m/min extrudiert und der extrudierte Rohling anschließend in einem Tempcr-Tunnel bei einer Innentemperatur von 200° C zum Elastomerschlauch vulkanisiert.

Nach dem Austritt aus dem Temper-Tunnel kühlt der Silikonkautschukschlauch in der Strecke auf eine Temperatur von ca. 100° C ab, er wird dann über einen Rollensatz durch eine Ringdüse geführt, wo er beschichtet wird, anschließend wird er auf einer Trommel aufgewickelt.

Folgende Verfahrensparameter werden angewandt:
- das Reaktionsgas ist wie folgt zusammengesetzt:
   HMDSO Durchsatz 0,47 1/min
   Propangas Durchsatz 8 1/min
   Luft Durchsatz 160 1/min
- Abstand Flammenkegel - Oberfläche 10-20 mm (Spanne aufgrund der schrägen Anordnung der Düsen).

Die Prüfung des gemäß der Erfindung beschichteten Silikonkautschukschlauches ergab folgende Ergebnisse:

### 1. Reibungstest

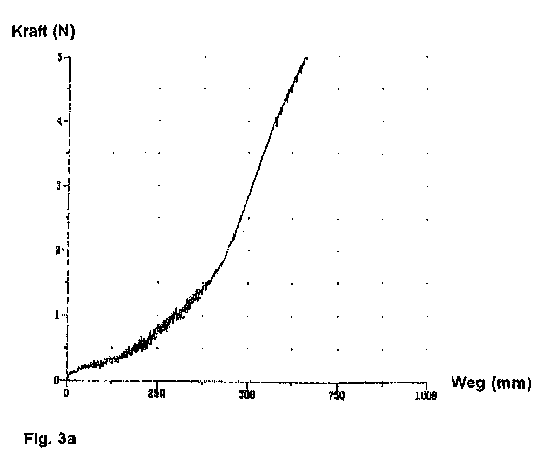

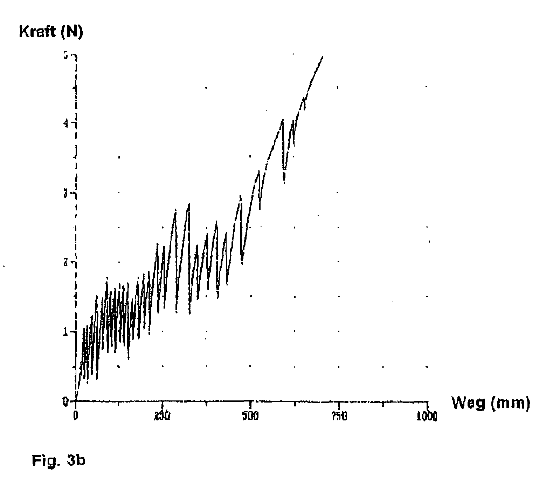

In Fig. 3a, 3b ist eine graphische Darstellung der Ergebnisse des Reibungstests der mit der erfindungsgemäßen Gleitschicht ausgestatteten Schlauchoberfläche (Fig. 3a) im Vergleich zur unbehandelten Schlauchoberfläche (Fig. 3b) als Kraft-Weg-Diagramme wiedergegeben.
Die Messkurven zeigen, dass die Beschichtung das Gleitverhalten signifikant ändert und der am nicht beschichteten Substrat auftretende Slip-Stick-Effekt nahezu eliminiert ist.
Hierzu wurde der "Knotentest" durchgeführt. Dazu wird der Schlauch zu einem Knoten verschlungen, die Enden des Knotens in eine Zugprüfmaschine eingespannt und die Enden des Schlauches auseinandergezogen. Dadurch wird der Knoten zugezogen und es reibt Oberfläche auf Oberfläche des Schlauches. Die dargestellten Kraft-Weg-Diagramme werden dabei ermittelt.

Der Schlauch hatte bei dem "Knotentest" einen Außendurchmesser von 6 mm bei einer Wandstärke von 1 mm. Die Gesamtlänge des verwendeten Schlauchstücks betrug 450 mm. Der Knoten befand sich in der Mitte des Schlauchstücks. Es wurde eine Einspannlänge in der Zugprüfmaschine vor 200 mm gewählt. Zu Beginn der Messung lag der Schlauch mit dem Knoten in der Zugprüfmaschine gestreckt vor, jedoch noch ohne Zugspannung. Der Knoten wurde mit einer definierten Geschwindigkeit v = 50 mm/min. zugezogen. Dabei wurde die Zugkraft zwischen den eingespannten Schlauchenden in Abhängigkeit vom Zugweg gemessen und in den Diagrammen nach den Fig. 3a und 3b dargestellt.

### 2. Weitere Eigenschaften

Die für Katheter relevanten medizinischen Tests zeigten folgende Ergebnisse:
- die aufgebrachte Siloxan-/Silanolsehiellt ist pyrogenfrei und zeigt weder Cytotoxizität noch Hämolyse,
- bei den üblichen Sterilisationsverfahren, nämlich
- Heißdampfsterilisation bei 121° C
- ETO-Gas bei max. 60° C
- Gamma-Bestrahlung bei 40 kGy
   findet keine signifikante Verschlechterung der Gleitfähigkeit statt,
   - keine verfahrensbedingte Partikelkontamination,
   - keine Veränderung der Gleitfähigkeit der Schicht nach Abreiben der Schlauchoberfläche mit Desinlektionsmittel (70%-ige Isopropanollösung).

## Patentansprüche

1. Verfahren zur Herstellung eines Schlauchs mit folgenden Schritten:
- Extrusion des Schlauches in einer Extrusionslinie,
- Modifikation einer Silikonkautschukoberfläche des Schlauchs durch Beschichten mit einer Funktionsschicht derart, dass eine Reduzierung einer Adhäsion bzw. Klebrigkeit, gemessen mit Hilfe des Knotentests, der Silikonkautsohukoberfläche erfolgt,
**dadurch gekennzeichnet, dass**
- aus einer Flamme eine silikathaltige Funktionsschicht auf der Silikonkautschukoberfläche abgeschieden wird und
- die Modifikation integriert in der Extrusionslinie erfolgt.

2. Verfahren nach Anspruch 1, **dadurch gekennzeichnet, dass** folgende Gaszusammensetzungen zur Erzeugung der Flamme eingesetzt werden:
Verhältnis der Gasmengen Brenngas : Luft von 1 : 15 bis 1 : 25
und
Anteil des schichtbildenden Gases von 0,1 bis 1 % am Gesamtgasstrom.

3. Verfähren nach Anspruch 1 und 2, **dadurch gekennzeichnet, dass** eine Funktionsschicht mit einer Dicke von 40 bis 100 nm abgeschieden wird.

4. Verfahren nach Anspruch 1 und 2, **dadurch gekennzeichnet, dass** als Brenngas Propan oder Butan oder Erdgas oder Methan oder Wasserstoff oder eine Mischung der vorgenannten Gase eingesetzt wird.

5. Verfahren nach Anspruch 1 und 2, **dadurch gekennzeichnet, dass** Luft oder Sauerstoff oder ein Sauerstoff enthaltendes Gasgemisch eingesetzt wird.

6. Verfahren nach Anspruch 1 und 2, **dadurch gekennzeichnet, dass** als schichtbildendes Gas Hexamethyldisiloxan (HMDSO) oder Tetramethoxysilan oder Tetraethoxysilan oder ein anderes Alkoxysilan oder Trimethylsilan oder eine zyklische Silanverbindung eingesetzt wird.

7. Verfahren nach Anspruch 2, **dadurch gekennzeichnet, dass** das Verhältnis der Gasmengen Brenngas: Luft vorzugsweise zu 1 : 20 gewählt wird.

8. Verfahren nach Anspruch 2, **dadurch gekennzeichnet, dass** der Anteil des schichtbildenden Gases vorzugsweise zu 0,2 bis 0,4 % am Gesamtgasstrom gewählt wird.

9. Verfahren nach einem der vorangehenden Ansprüche, **dadurch gekennzeichnet, dass** die silikathaltige Funktionsschicht bei Atmosphärendruck abgeschieden wird.

10. Verfahren nach einem der vorangehenden Ansprüche, **dadurch gekennzeichnet, dass** der Abstand Flammenkegel - Silikonkautschukoberfläche so gewählt wird, dass dieser der Beziehung gentigt:
Abstand im Bereich von x bis 2x, vorzugsweise von x bis 1,5x, wobei x den Abstand von der Düsenspitze zur Flammkegelspitze darstellt.

11. Verfahren nach einem der vorangehenden Ansprüche, **dadurch gekennzeichnet, dass** die Flamme mit einer Geschwindigkeit zwischen 1 und 50 m/min, bevorzugt zwischen 10 und 20 m/min, über die Silikonkautschukoberfläche hinweggeführt wird.

12. Verfahren nach einem der vorangehenden Ansprüche, **dadurch gekennzeichnet, dass** die Flamme mittels eines Düsenkoples erzeugt wird, wobei der Düsenkopf ringförmig oder linear bzw. annähernd linear ausgeführt ist.

13. Verfahren nach einem der vorangehenden Ansprüche, **dadurch gekennzeichnet, dass** die Beschichtung der Silikonkautschukoberfläche eines Fomiteils in der Fertigungsstrecke für das Formteil durchgeführt wird.

14. Schlauch aus Silikonkautschuk mit einer modifizierten Oberfläche in Form einer Funktionsschicht, hergestellt mit einem Verfahren nach einem der Ansprüche 1 bis 13 **dadurch gekennzeichnet, dass** die Funktionsschicht eine Zusammensetzung [SiO₂(OH)]ₙ aufweist, wobei zur Erzeugung der Flamme ein Gas enthaltend HMDSO, Propangas und Luft eingesetzt wird.

15. Schlauch nach Anspruch 14, **dadurch gekennzeichnet, dass** die Funktionsschicht als Sitanol-/Siloxanschicht ausgebildet ist.

## Claims

1. Process for producing a tube with the following steps:
- Extrusion of the tube in an extrusion line,
- modifying a silicone rubber surface of the tube by coating with a functional layer such that, determined by means of the knot test, a reduced adhesion and tackiness, respectively, of the silicon rubber surface results,
**characterised in that**
- a silicate-containing functional layer is deposited from a flame on the silicone rubber surface and
- the modification is integrated in the extrusion line.

2. Process according to claim 1, **characterised in that** the following gas compositions are used to generate the flame:
Fuel gas to air ratio of from 1:15 to 1:25, in terms of the quantities of gas, and
layer-forming gas content of from 0.1 to 1 % of the total gas flow.

3. Process according to claim 1 and 2, **characterised in that** a functional layer having a thickness of from 40 to 100 nm is deposited.

4. Process according to claim 1 and 2, **characterised in that** propane or butane or natural gas or methane or hydrogen or a mixture of the aforementioned gases is used as the fuel gas.

5. Process according to claim 1 and 2, **characterised in that** air or oxygen or a gas mixture containing oxygen is used.

6. Process according to claim 1 and 2, **characterised in that** hexamethyldisiloxane (HMDSO) or tetramethoxysilane or tetraethoxysilane or another alkoxysilane or trimethylsilane or a cyclic silane compound is used as the layer-forming gas.

7. Process according to claim 2, **characterised in that** the fuel gas to air ratio is preferably selected at 1:20 in terms of the quantities of gas.

8. Process according to claim 2, **characterised in that** the proportion of the layer-forming gas is preferably selected at 0.2 to 0.4 % of the total gas flow.

9. Process according to any one of the preceding claims, **characterised in that** the silicate-containing functional layer is deposited under atmospheric pressure.

10. Process according to any one of the preceding claims, **characterised in that** the distance flame cone - silicone rubber surface is selected in such a way that it satisfies the relationship:
Distance in the range of from x to 2x, preferably from x to 1.5x,
wherein x represents the distance from the tip of the nozzle to the tip of the flame cone.

11. Process according to any one of the preceding claims, **characterised in that** the flame is moved over the silicone rubber surface at a rate of between 1 and 50 m/min, preferably between 10 and 20 m/min.

12. Process according to any one of the preceding claims, **characterised in that** the flame is produced by a nozzle head, the nozzle head being annular, or linear and approximately linear, respectively.

13. Process according to any one of the preceding claims, **characterised in that** the silicone rubber surface of a moulding is coated in the moulding production line.

14. Tube made of silicone rubber having a modified surface in the form of a functional layer, produced by a process according to any one of claims 1 to 13 **characterised in that** the functional layer has a composition [SiO₂(OH)ₙ], wherein for producing the flame a gas containing HMDSO, propane gas and air is used.

15. Tube according to claim 14, **characterised in that** the functional layer is formed as a silanol/siloxane layer.

## Revendications

1. Procédé de fabrication d'un tuyau comprenant les étapes suivantes :
- extrusion du tuyau sur une ligne d'extrusion,
- modification de la surface en caoutchouc de silicone du tuyau par un revêtement avec une couche de fonction de telle sorte qu'il en résulte une réduction de l'adhésion, respectivement du collage, sur la surface en caoutchouc de silicone, mesurée à l'aide du test de la boucle,
**caractérisé en ce**
- **qu'**une couche de fonction contenant du silicate se trouve créée sur la surface en caoutchouc de silicone à l'aide d'une flamme, et
- **que** la modification est produite intégrée dans la ligne d'extrusion.

2. Procédé selon la revendication 1 **caractérisé en ce que** les compositions en gaz suivantes sont employées pour la génération de la flamme :
rapport des quantités de gaz de combustion :
d'air : de 1 : 15 à 1 : 25, et
proportion du gaz formant la couche entre 0,1 et jusqu'à 1 % du flux gazeux total.

3. Procédé selon les revendications 1 ou 2 **caractérisé en ce qu'**une couche de fonction avec une épaisseur de 40 à 100 nm est déposée.

4. Procédé selon les revendications 1 ou 2 **caractérisé en ce que** du propane, ou du butane, ou du gaz naturel, ou du méthane, ou de l'hydrogène, ou un mélange des gaz précités est employé en tant que gaz de combustion.

5. Procédé selon les revendications 1 ou 2 **caractérisé en ce que** de l'air, ou de l'oxygène, ou un mélange gazeux contenant de l'oxygène, est employé.

6. Procédé selon les revendications 1 ou 2 **caractérisé en ce que** de l'hexaméthyldisiloxane (HMDSO), ou du tétraméthoxysilane, ou du tétraéthoxysilane, ou un autre alcoxysilane, ou triméthylsilane, ou un composé de silane cyclique, est employé.

7. Procédé selon la revendication 2 **caractérisé en ce que** le rapport des quantités de gaz de combustion : air est de préférence choisi égal à 1 : 20.

8. Procédé selon la revendication 2 **caractérisé en ce que** la proportion du gaz formant le revêtement est choisie égale, de préférence, entre 0,2 et 0,4 % du flux total gazeux.

9. Procédé selon l'une des revendications précédentes **caractérisé en ce que** la couche de fonction contenant du silicate est déposée à la pression atmosphérique.

10. Procédé selon l'une des revendications précédentes **caractérisé en ce que** la distance coeur de la flamme-surface de caoutchouc en silicone est choisie de telle sorte que celle-ci satisfait à la relation :
distance dans un domaine entre X et 2X, de préférence entre X et 1,5X, où x représente la distance de la pointe de la buse à la pointe du coeur de la flamme.

11. Procédé selon l'une des revendications précédentes **caractérisé en ce que** la flamme est passée sur la surface de caoutchouc en silicone avec une vitesse entre 1 et 50 m/min, de préférence entre 10 et 20 m/min.

12. Procédé selon l'une des revendications précédentes **caractérisé en ce que** la flamme est générée à l'aide d'une tête de buse, la tête de buse étant conçue de façon linéaire, ou respectivement à peu près linéaire.

13. Procédé selon l'une des revendications précédentes **caractérisé en ce que** le revêtement de la surface de caoutchouc en silicone est conçu sous la forme d'un moulage dans la partie de l'achèvement du moulage.

14. Tuyau en caoutchouc de silicone comprenant une surface modifiée sous la forme d'une couche de fonction, fabriqué avec un procédé selon l'une des revendications de 1 à 13 **caractérisé en ce que** la couche de fonction présente une composition en [SiO₂(OH))ₙ, où un gaz contenant du HMDSO, du gaz propane, et de l'air est employé pour la génération de la flamme.

15. Tuyau selon la revendication 14 **caractérisé en ce que** la couche de fonction est conçue sous la forme d'une couche silanol-/siloxane.
